# EUROPEAN PATENT APPLICATION

(11) **EP 3 902 013 A1**
(43) Date of publication of application: **27.10.2021**
(21) Application number: 21170138.8
(22) Date of filing: 23.04.2021
(51) Int. Cl.: H01L 29/417, H01L 29/78, H01L 23/522, H01L 29/49

(54) **FIELD-EFFECT TRANSISTOR**

(30) Priority: 24.04.2020 NL 2025421
(71) Applicant: Ampleon Netherlands B.V., 6534 AV Nijmegen (NL)
(72) Inventor: De Boet, Johannes Adrianus Maria, 6534 AV Nijmegen (NL)
(74) Representative: Arnold & Siedsma

(57) **Abstract**

The present invention relates to a field-effect transistor. Furthermore, the present invention relates to a semiconductor die comprising such a field-effect transistor and to an amplifier package comprising such a semiconductor die.

By using a gate resistor that is distributed over the plurality of gate fingers instead of a localized resistor, it becomes possible to use wider gate fingers without substantially increasing the risk of instabilities. When each individual gate finger is wider, the number and/or size of the gate finger bases and drain finger bases can be reduced, while still having the same total gate width. The present invention therefore allows a layout to be used having less parasitic effects, thereby increasing the efficiency of the field-effect transistor.

## Description

The present invention relates to a field-effect transistor. Furthermore, the present invention relates to a semiconductor die comprising such a field-effect transistor and to an amplifier package comprising such a semiconductor die. The invention particularly relates to field-effect transistors capable of outputting high powers, i.e. more than 200W per die at moderately high frequencies, i.e. between 200 and 800 MHz.

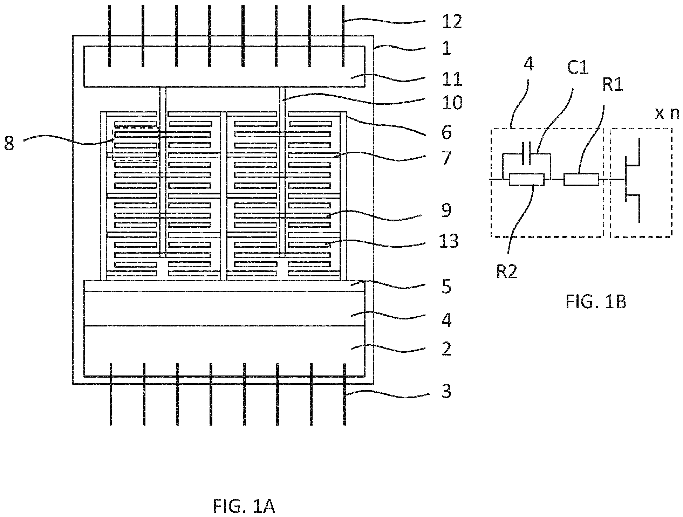

Field-effect transistors are known in the art. Figure 1A illustrates a semiconductor die 1 on which a field-effect transistor is arranged. This transistor comprises a gate bondbar 2 to which bondwires 3 are bonded for receiving an input signal. Gate bondbar 2 is connected to an RC-filter 4 that is schematically illustrated as a box in between gate bondbar 2 and a gate bar 5.

From gate bar 5 a plurality of gate runner bases 6 extend. Each gate runner base 6 is connected to a plurality of gate runners 7. Each gate runner 7 corresponds to a respective field-effect transistor element 8. Such element further comprises a drain runner 9 and a source shield 13. Drain runners 9 are connected to drain runner bases 10 which in turn are connected to a drain bondbar 11. From this latter bondbar, bondwires 12 extend for outputting an output signal.

The field-effect transistor may be embodied as a laterally diffused metal-oxide-semiconductor, 'LDMOS', transistor of which the details are well known.

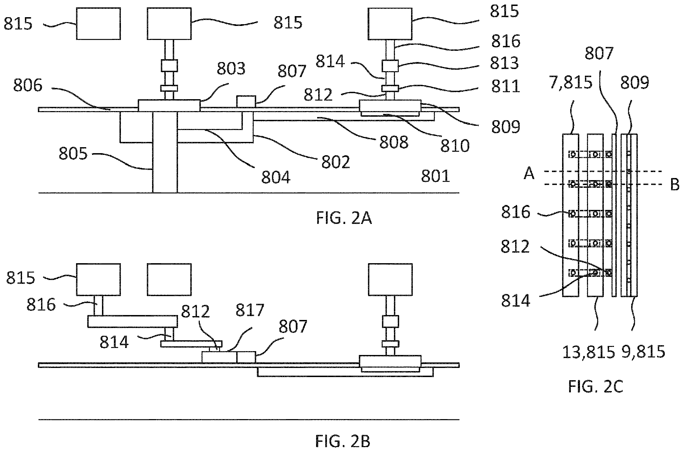

Figures 2A-2C present different views of field-effect transistor element 8. Figure 2C presents a schematic top view indicating two lines A, B of which a corresponding cross-sectional view is depicted in figures 2A and 2B, respectively. It is noted that figures 2A-2C are not true to scale for illustrative purposes.

As shown in figure 2A, field-effect transistor element 8 comprises a p-type substrate 801 that includes a p-type epitaxial layer. A source contact 803 is realized on top of a diffused p-well 802. An n-type doped contact region 804 is present underneath source contact 803 to reduce the ohmic contact resistance. Optionally, source contact 803 can be embodied as an elongated source finger (not shown). In other embodiments, the top layer of substrate 801 is silicidized at the position of the source contact and a dedicated source contact layer is omitted.

A highly doped p-type sinker 805 allows a low ohmic contact between source contact 803 and the backside of semiconductor die 1, which is typically grounded.

Substrate 801 is largely covered by a gate oxide layer 806 on top of which an elongated gate finger 807 is arranged.

An n-type doped drift region 808 extends next to p-well 802 up to elongated drain finger 809. Also here, an n-type doped contact region 810 is used to lower the ohmic contact resistance.

Typically, gate finger 807 and drain finger 809 are realized using silicidized polysilicon. For high power applications, the electrical resistivity and/or current carrying capabilities of this material are too low. To this end, thicker metal layers are provided in the form of a metal layer stack. Connections to the various layers of the metal layer stack are realized using one or more vias. For example, connection between the polysilicon layer and first metal layer 811 is realized using vias 812, connection between first metal layer 811 and second metal layer 813 using vias 814, and connection between second metal layer 813 and third metal layer 815 using vias 816. The part of third metal layer 815 connected to gate finger 807 corresponds to gate runner 7 in figure 1A. Similarly, the part of third metal layer 815 connected to drain finger 809 corresponds to drain runner 9 in figure 1A. Furthermore, the part of third metal 815 that is connected to source contact 803 corresponds to source shield 13. As shown, source shield 13 extends in between gate runner 7 and drain runner 9 and thereby acts as a shield for reducing the gate-drain capacitance. Typically, source shield 13 is grounded to the substrate. In other embodiments, the source shield is omitted.

Gate finger 807 is electrically connected at a plurality of spaced apart positions to gate runner 7. As shown in figure 2B, the connection between gate finger 807 and gate runner 7 is achieved using staggered vias 812, 814, 816. These vias do not start from gate finger 807 as this is typically a very short structure in the order of micrometers. Instead, a gate island 817 is formed that extends towards source contact 803 and from which via 812 extends to first metal 811. As shown, p-well 802 and/or contact region 804 are absent underneath gate island 817. This may also hold for contact region 810 and drift region 808.

The gain of the field-effect transistor is frequency dependent. Generally, the gain will drop as frequency increases. This may pose a problem for transistors that should operate at relatively low frequencies. More in particular, at low frequencies, where the gain is still relatively high, instabilities may occur.

When the transistor should output high powers, a high total gate width is used. A high total gate width can be achieved using a large number of parallel gate fingers and/or using gate fingers that are relatively wide. Here it is noted, that a gate finger is an elongated structure extending along a given direction. The wording gate width is used to denote the dimension of the gate finger along this given direction, whereas the wording length is used to denote the dimension of the gate finger perpendicular to this given direction.

To reduce instability problems, particularly at high output powers and relatively low frequencies, a gate layout is used as shown in figure 1A. In this layout, the individual gate fingers are not wide to avoid instability problems. To still be able to meet the target output power requirement a lot of these gate fingers are put in parallel. Additionally, an RC-filter is used that is arranged in series with the gate fingers. In the exemplary RC-filter shown in figure 1B, a first resistor R1 is arranged in series with a parallel connection of a second resistor R2 and capacitor C1. This RC-filter is effectively in series with the n field-effect transistor elements that are comprised by the field-effect transistor.

At low frequencies, the effective resistance in series equals R1+R2, whereas at high frequencies, the effective resistance equals R1. As a high series resistance reduces the overall gain, the RC-filter enables the gain increase for decreasing frequencies to be at least partially compensated.

It is generally known that obtaining high power efficiency figures is difficult when using a gate layout as shown in figure 1A. For example, the various routing elements such as gate finger bases 6 and drain finger bases 10 do not add to the signal amplification but rather introduce parasitic effects, such as parasitic gate-drain capacitance and parasitic drain-source capacitance, and introduce signal delays that deteriorate the overall performance of the field-effect transistor.

An object of the present invention is to provide a field-effect transistor that is able to operate in the abovementioned high output power and low frequency range with improved power efficiency.

According to the present invention, this object is achieved using the field-effect transistor as defined in claim 1, which comprises a plurality of field-effect transistor elements, each field-effect transistor element comprising a gate finger, and a gate runner, wherein the gate finger of each field-effect transistor element is electrically connected at a plurality of spaced apart positions to the gate runner of that element, and wherein each gate finger is made of a first material or material composition and has a first electrical resistivity.

The field-effect transistor of the present invention is characterized in that it comprises, for each gate finger, a gate resistor through which the electrical connection between the gate finger and the gate runner at a position among the plurality of spaced apart positions is realized, wherein the gate resistor is made of a second material or material composition and has a second electrical resistivity that is higher than the first electrical resistivity.

The Applicant has found that by using a gate resistor that is distributed over the plurality of gate fingers instead of a localized resistor such as resistor R1 in figure 1A, it becomes possible to use wider gate fingers without substantially increasing the risk of instabilities. When each individual gate finger is wider, the number and/or size of the gate finger bases and drain finger bases can be reduced while still having the same total gate width. The present invention therefore allows a layout to be used having less parasitic effects, thereby increasing the efficiency of the field-effect transistor.

The second electrical resistivity can be at least 10 times greater than the first electrical resistivity, preferably at least 50 times. Additionally or alternatively, the field-effect transistor comprises, for each gate finger, a plurality of gate resistors, each gate resistor corresponding to a respective position among the plurality of said spaced apart positions. The field-effect transistor preferably comprises, for each gate finger, a respective gate resistor for each of the spaced apart positions.

For each gate finger, the plurality of gate resistors can be identical. Additionally or alternatively, all the gate resistors of the field-effect transistor can be identical.

The first material or material composition can be identical to the second material or material composition. In such case, the difference in electrical resistivity is obtained by using a different processing of this material or material composition for the gate fingers and gate resistors. For example, the gate resistors and gate fingers can both be made from polysilicon, wherein the polysilicon of the gate fingers has been silicidized, and wherein the polysilicon of the gate resistors has not been silicidized. The process of silicidization decreases the electrical resistivity of the polysilicon. A low resistivity is required for the gate fingers but may be unwanted for the gate resistors. Using suitable masking techniques, for example using a patterned photoresist and/or a patterned oxide or nitride layer, the polysilicon can be selectively silicidized thereby allowing the electrical resistivities of the gate fingers and gate resistors to be different.

In addition, the polysilicon of the gate fingers may have been subjected to a dopant diffusion step for decreasing the electrical resistivity of the gate fingers. Such dopant diffusion step may not or may hardly have been applied to the gate resistor. By varying the dopant diffusion, a different temperature behavior of the polysilicon gate resistor can be achieved. Preferably, the temperature behavior of the gate resistor is such that it decreases with temperature to compensate an increase in the intrinsic gain of the field-effect transistor elements. Such behavior is generally obtained when the dopant diffusion step is not applied.

The gate runner may extend in parallel to the gate finger. Furthermore, the gate runner can be made of a metal or metal composition having a third electrical resistivity that is substantially lower than the first electrical resistivity. For example, the first electrical resistivity is at least 50 times greater than the third electrical resistivity, preferably at least 150 times. For example, the metal or metal composition may comprise a gold layer or other layer having a very low electrical resistivity.

Each gate resistor may comprise a first end at which the gate resistor is connected to the gate finger, and a second end opposite to the first end, wherein the field-effect transistor comprises, for each gate resistor, one or more vias for connecting the gate resistor at or near the second end to the gate runner.

The plurality of gate fingers may extend in parallel, and during operation, the gate currents in each gate finger may flow in substantially the same direction.

The field-effect transistor may comprise a Si-based laterally diffused metal-oxide semiconductor, 'LDMOS', transistor, or a GaN-based high electron mobility transistor, 'HEMT'.

The field-effect transistor may further comprise, for each field-effect transistor element, a doped source region and a doped drain region that each extend in parallel to the gate finger of that element on a first and second side of the gate finger, respectively, wherein the plurality of spaced apart positions are arranged on the first side of gate finger. Furthermore, each gate finger may extend along a respective first direction, and wherein each gate finger comprises an elongated main section that extends along the first direction, and, for each of the spaced apart positions, a gate island that is connected to the main section and extends perpendicular to the first direction. Each gate resistor can be connected in between a respective gate island and the gate runner, and/or wherein each gate resistor at least partially forms the corresponding respective gate island. The gate resistors can be arranged on a relatively thick oxide layer, e.g. a LOCOS layer, for decreasing a gate-source capacitance of the field-effect transistor. In addition, near the gate resistors, the p-wells and source regions are interrupted. This prevents the dopants that are associated with the formation of the p-wells and source regions to also dope the gate resistors thereby reducing their resistance.

The field-effect transistor may further comprise a plurality of drain fingers, each drain finger being associated with a respective gate finger and being electrically connected to the corresponding doped drain region.

The field-effect transistor may further comprise a gate bondbar that extends in the second direction and that is electrically connected to the gate fingers, and it may comprise a drain bondbar to which the drain fingers are electrically connected, wherein the drain bondbar is opposite to the gate bondbar.

The field-effect transistor may further comprise an RC-filter in between the gate bondbar and the plurality of gate fingers, wherein the RC-filter comprises a parallel connection of a resistor and a capacitor. Contrary to the gate resistor, the RC-filter is not distributed over the gate fingers. Put differently, before the signal to be amplified is fed to the field-effect transistor elements it has passed through the RC-filter.

According to a second aspect, the present invention provides a semiconductor die comprising the field-effect transistor as defined above.

According to a third aspect, the present invention provides an amplifier package, comprising a substrate and the semiconductor die described above arranged on the substrate. The package further comprises an input lead and an output lead each arranged spaced apart from the substrate and the semiconductor die, a first plurality of bondwires extending along the first direction from the input lead to the gate bondbar, and a second plurality of bondwires extending along the first direction from the output lead to the drain bondbar.

Next, the present invention will be described in more detail by referring to the appended drawings, wherein:
Figures 1A-1B schematically illustrate a known field-effect transistor and an equivalent circuit thereof;
Figures 2A-2C illustrate various views corresponding to the field-effect transistor of figure 1A;
Figures 3A-3C schematically illustrate a field-effect transistor and amplifier package in accordance with the present invention;
Figures 4A-4B illustrate cross-sectional views corresponding to the field-effect transistor of figure 3A;
Figures 5A-5E illustrate various processing stages for realizing a polysilicon gate resistor used in the field-effect transistor of figure 3A.

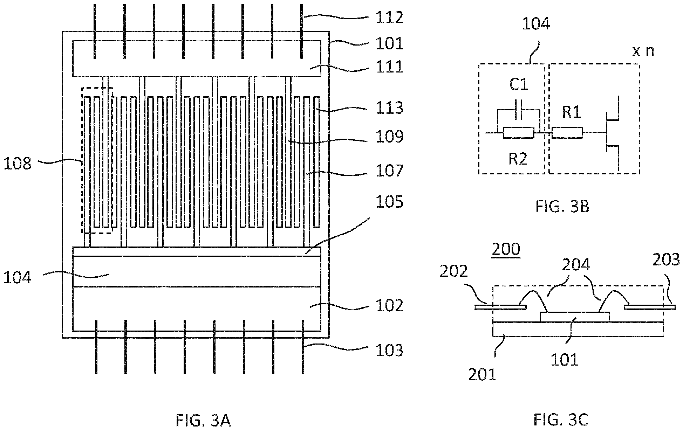

Figure 3A illustrates a semiconductor die 101 comprising a field-effect transistor in accordance with the present invention. The field-effect transistor comprises a gate bondbar 102 to which bondwires 103 are bonded for receiving an input signal. Gate bondbar 102 is connected to an RC-filter 104 that is schematically illustrated as a box in between gate bondbar 102 and gate bar 105.

From gate bar 105 a plurality of gate runners 107 extend. Each gate runner 107 corresponds to a respective field-effect transistor element 108. Such element further comprises a drain runner 109, and a source shield 113. The field-effect transistor is embodied as a laterally diffused metal-oxide-semiconductor, 'LDMOS', transistor of which the details are well known.

Drain runners 109 are connected to a drain bondbar 111. From this latter bondbar bondwires 112 extend for outputting an output signal.

RC-filter 104 differs from RC-filter 4 of figure 1B in that gate resistor R1 is distributed over the n field-effect transistor elements 108. The Applicant has found that this arrangement of the gate resistor considerably improves the stability of the overall field-effect transistor to such an extent that a gate layout can be used as shown in figure 3A. This arrangement presents a more efficient use of die area and introduces less parasitic effects when compared to the gate layout shown in figure 1A. Consequently, the power efficiency of the resulting field-effect transistor can be greatly improved.

Figure 3C illustrates how semiconductor die 101 can be used inside an amplifier package 200. Here, package 200 comprises a heat-conducting substrate 201 on which semiconductor die 101 is mounted. Package 200 further comprises an input lead 202 and an output lead 203 that both extend from the outside to the inside of package 200. Bondwires 204 are used for connecting these leads to gate bondbar 102 and drain bondbar 111, respectively.

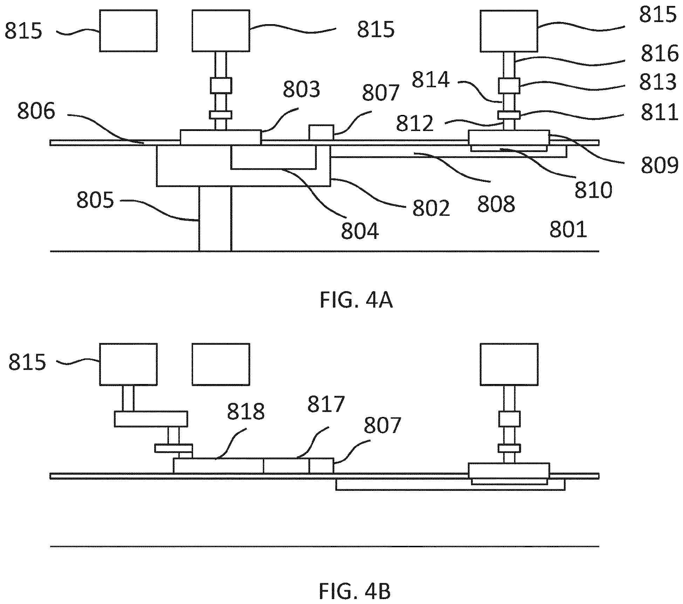

The top layout of the field-effect transistor of figure 3A largely corresponds to that of figure 2C. The cross-sectional views corresponding to lines A and B of figure 2C are illustrated in figures 4A and 4B, respectively, where the same reference signs have been used to refer to identical or similar components.

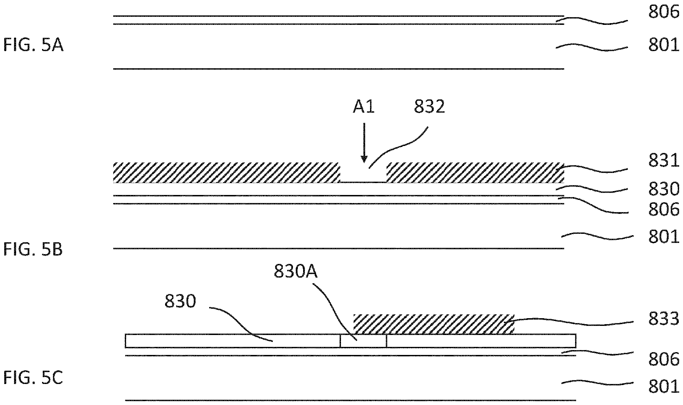

A crucial difference between the field-effect transistor of figure 4B and that of figure 2B is the presence of gate resistor 818 that extends from gate island 817. Gate resistor 818 can be made of the same material as gate island 817, e.g. polysilicon. However, as the function of gate resistor 818 is to improve stability, the resistance of gate resistor 818 should be much higher than that of gate island 817. This difference in resistance can be achieved using a different processing of the polysilicon as will be explained later with reference to figures 5A-5E.

It should be noted that a clear distinction between gate island 817 and gate resistor 818 is not always possible. The purpose of gate island 817 is to enable a connection between the gate finger, which has a short gate length, and the upper metal layers 811, 813, 815. This function can also be at least partially achieved using gate resistor 818. However, as the processing of gate resistor 818 should not affect gate finger 807, some margin should preferably be observed.

In an example, RC filter 4 in figure 1B may comprise the values of R1=0.7 Ohm, R2=12 Ohm, and C1= 300 pF. This would roughly translate into an RF-filter 104 in which similar values for R2 and C1 are used, but, due to the distribution of R1, a value of 3200 Ohm should be used for each gate resistor 818 in each field-effect transistor element 108.

Figures 5A-5E illustrate an example of processing polysilicon to achieve the simultaneous formation of a gate contact, a gate island, and a gate resistor in accordance with the present invention.

As a first step, shown in figure 5A, a SiO2 gate oxide 806 is deposited on substrate 801. Thereafter, as shown in figure 5B, a layer of polysilicon 830 is provided on top of gate oxide 806. This layer is masked using a masking layer 831 such as photoresist or an oxide or nitride to provide selective openings 832 through which a dopant can be diffused into the polysilicon according to arrow A1. Hereinafter, the doped region of polysilicon layer 830 will be referred to as region 830A.

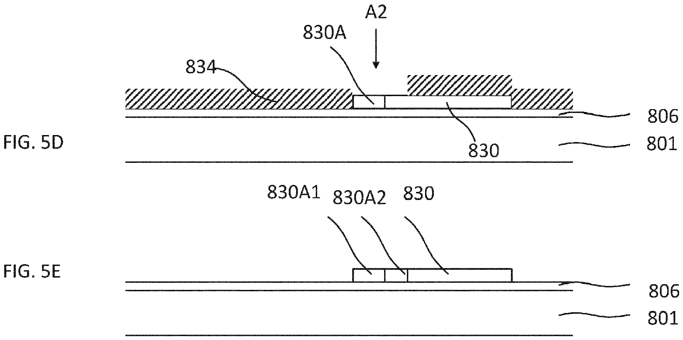

Next, as shown in figure 5C, another masking layer 833 will be provided for patterning polysilicon layer 830, 830A. More in particular, the non-masked regions of this layer will be removed as shown in figure 5D. Next, another masking layer 834 will be used for defining the areas of the polysilicon that should be silicidized. The process typically comprises depositing a metal layer on top of the polysilicon as illustrated by arrow A2 and subsequently performing an annealing step to cause the polysilicon and the metal to react. This will result in two regions as shown in figure 5E, i.e. a region 830A1 which has been subjected to dopant diffusion and silicidization, and a region 830A1 which has only been subjected to silicidization. Here, in figure 5E, region 830 could be used as gate resistor 818, region 830A2 as gate island 817, and region 830A1 as gate finger 807.

In the above, the present invention has been explained using embodiments thereof. However, the skilled person will appreciate that the present invention is not limited to these embodiments but that various modifications are possible without deviating from the scope of the invention which is defined by the appended claims.

## Claims

1. A field-effect transistor comprising a plurality of field-effect transistor elements, each field-effect transistor element comprising a gate finger, and a gate runner, wherein the gate finger of each field-effect transistor element is electrically connected at a plurality of spaced apart positions to the gate runner of that element, and wherein each gate finger is made of a first material or material composition and has a first electrical resistivity;
**characterized in that** the field-effect transistor further comprises, for each gate finger, a gate resistor through which the electrical connection between the gate finger and the gate runner at a position among the plurality of spaced apart positions is realized, said gate resistor being made of a second material or material composition and having a second electrical resistivity that is higher than the first electrical resistivity.

2. The field-effect transistor according to claim 1, wherein the second electrical resistivity is at least 10 times greater than the first electrical resistivity, preferably at least 50 times.

3. The field-effect transistor according to claim 1 or 2, wherein the field-effect transistor comprises, for each gate finger, a plurality of gate resistors, each gate resistor corresponding to a respective position among the plurality of said spaced apart positions, wherein the field-effect transistor preferably comprises, for each gate finger, a respective gate resistor for each of the spaced apart positions;
wherein, for each gate finger, the plurality of gate resistors are preferably identical, all the gate resistors of the field-effect transistor preferably being identical.

4. The field-effect transistor according to any of the previous claims, wherein the first material or material composition is identical to the second material or material composition, wherein the difference in electrical resistivity is obtained by using a different processing of this material or material composition for the gate fingers and gate resistors.

5. The field-effect transistor according to claim 3 or 4, wherein the gate resistors and gate fingers are both made from polysilicon, wherein the polysilicon of the gate fingers has been silicidized, and wherein the gate resistors have not been silicidized;
wherein the polysilicon of the gate fingers has preferably been subjected to a dopant diffusion step for decreasing the electrical resistivity of the gate fingers, and wherein the gate resistor has not or hardly been subjected to subjected to such a dopant diffusion step.

6. The field-effect transistor according to any of the previous claims, wherein the gate runner extends in parallel to the gate finger, and wherein the gate runner is made of a metal or metal composition having a third electrical resistivity that is substantially lower than the first electrical resistivity, wherein the first electrical resistivity is preferably at least 50 times greater than the third electrical resistivity, preferably at least 150 times.

7. The field-effect transistor according to any of the previous claims, wherein each gate resistor comprises a first end at which the gate resistor is connected to the gate finger, and a second end opposite to the first end, wherein the field-effect transistor comprises, for each gate resistor, one or more vias for connecting the gate resistor at or near the second end to the gate runner.

8. The field-effect transistor according to any of the previous claims, wherein the plurality of gate fingers extend in parallel, and wherein during operation, gate currents in each gate finger flow in substantially the same direction.

9. The field-effect transistor according to any of the previous claims, wherein the field-effect transistor comprises a Si-based laterally diffused metal-oxide semiconductor, 'LDMOS', transistor, or a GaN-based high electron mobility transistor, 'HEMT'.

10. The field-effect transistor according to any of the previous claims, further comprising, for each field-effect transistor element, a doped source region and a doped drain region that each extend in parallel to the gate finger of that element on a first and second side of the gate finger, respectively, wherein the plurality of spaced apart positions are arranged on the first side of gate finger.

11. The field-effect transistor according to claim 10, wherein each gate finger extends along a respective first direction, and wherein each gate finger comprises:
an elongated main section that extends along the first direction;
for each of the spaced apart positions, a gate island that is connected to the main section and that extends perpendicular to the first direction;
wherein each gate resistor is connected in between a respective gate island and the gate finger, and/or wherein each gate resistor at least partially forms the corresponding respective gate island;
wherein the doped source region is preferably interrupted near said plurality of spaced apart positions for decreasing a gate-source capacitance of the field-effect transistor.

12. The field-effect transistor according to claim 11, further comprising a plurality of drain fingers, each drain finger being associated with a respective gate finger and being electrically connected to the corresponding doped drain region.

13. The field-effect transistor according to claim 12, further comprising:
a gate bondbar that extends in the second direction, and that is electrically connected to the gate fingers; and
a drain bondbar that extends in the second direction, and that is electrically connected to the drain fingers, wherein the drain bar is opposite to the gate bar;
the field-effect transistor preferably further comprising an RC-filter in between the gate bondbar and the plurality of gate fingers, said RC-filter comprising a parallel connection of a resistor and a capacitor.

14. A semiconductor die comprising the field-effect transistor as defined in claim 13.

15. An amplifier package, comprising:
a substrate;
the semiconductor die of claim 14 arranged on the substrate;
an input lead and an output lead each arranged spaced apart from the substrate and the semiconductor die;
a first plurality of bondwires extending along the first direction from the input lead to the gate bondbar; and
a second plurality of bondwires extending along the first direction from the output lead to the drain bondbar.
